# EUROPEAN PATENT APPLICATION

(11) **EP 4 718 976 A1**
(43) Date of publication of application: **01.04.2026**
(21) Application number: 24203122.7
(22) Date of filing: 27.09.2024
(51) Int. Cl.: H10D 30/01, H10D 30/67, H10D 30/69, H10D 64/68, G06N 3/06

(54) **BACK END OF LINE COMPATIBLE FERROELECTRIC FIELD EFFECT TRANSISTOR TUNABLE PROBABILISTIC ELEMENT**

(71) Applicant: IMEC VZW, 3001 Leuven (BE)
(72) Inventor: KUMAR, Ankit, 3001 Heverlee (BE); LIN, Han Chung, 3001 Heverlee (BE); WALKE, Amey Mahadev, 3001 Heverlee (BE)
(74) Representative: Roth, Sebastian

(57) **Abstract**

This disclosure relates generally to a ferroelectric field effect transistor (FeFET) device suitable for probabilistic computing. The FeFET devices is usable as tunable probabilistic element in a network. A computing device comprising the network is also proposed. The FeFET device comprising a channel layer comprising an oxide semiconductor material and/or a 2D semiconductor material. The FeFET device further comprises a gate structure on the channel layer, the gate structure comprising a ferroelectric or anti-ferroelectric layer and a gate layer arranged on the ferroelectric or anti-ferroelectric layer. The gate structure is arranged between a source contact and a drain contact, which are additionally arranged on the channel layer.

## Description

### TECHNICAL FIELD

The present disclosure relates generally to ferroelectric field effect transistors (FeFETs) based devices. Specifically, a FeFET device suitable for probabilistic computing is proposed. The FeFET devices is usable as a tunable probabilistic element in a network, wherein the network may be employed by a computing device for probabilistic computing.

### BACKGROUND

Machine learning (ML) architectures use deep learning neural networks to solve various problems, such as cognitive recognition, robotics, and discovery. A deep neural network (DNN) in ML is a tunable network with many parameters, and may comprises interconnected neurons and synapses. Due to its complexity, the network is often treated as a black-box model, though there are ongoing efforts to create more transparent white-box models. However, uncertainty in predictions provided by the neural network makes it challenging to quantify false positives accurately. To increase the confidence in the results, large datasets and extensive networks are typically required. As a result, convergence to a solution becomes exceedingly difficult and computationally intensive.

In contrast, probabilistic neural network implementations can improve the confidence in the results by incorporating uncertainty, even when working with limited datasets. Probabilistic networks often achieve more efficient convergence toward a global optimum. However, their success depends heavily on carefully modeling the uncertainty. Specifically, probabilistic neural networks handle both parameter (weight matrix) and structural (architecture, activation function) uncertainty, thereby providing a formal framework to enhance confidence in results, and to explore unknowns by incorporating uncertainty.

An example of a probabilistic neural network is a Bayesian neural network. In such a Bayesian network implementation, a Gibbs sampler requires highly efficient tunable stochastic sampling, as the network consumes significant energy in generating stochastic samples. Therefore, a key metric is how efficiently these samples can be generated in the reconfigurable network, whether operating synchronously or asynchronously.

In summary, high throughput (e.g., GHz sampling speeds), efficient tunability of probabilistic samples, and dense device integration at all possible network nodes, are crucial factors for the performance of probabilistic networks.

On-chip probabilistic sampling can be implemented using digital Complementary Metal Oxide Semiconductor (CMOS) circuits, magnetic random-access memory (MRAM), or unstable ferroelectric field-effect transistors (FeFETs). The conventional CMOS solutions provide pseudo-probabilistic samples, but are limited by lower speeds and significant energy and area requirements. Magnetic nanodevices are more energy- and area-efficient, and offer efficient digital sampling. However, they present challenges in terms of complex integration processes, difficulties with 3D integration, and susceptibility to external magnetic fields.

Among these above technologies, the FeFET devices thus stand out, as they are energy- and area-efficient, and capable of providing both digital and analog samples. This makes them a promising option for probabilistic networks. Specifically, FeFET devices with reduced or negligible ferroelectric hysteresis may offer the potential for high throughput per unit energy and area, which further enhances their suitability for such network applications.

However, key concerns for FeFET device integration in probabilistic networks include BEOL compatibility, GHz sampling capabilities, and an efficient and bias-free tunability of memory state fluctuations between the '0' and '1' states.

### SUMMARY

In view of the above, this disclosure has the objective to provide a FeFET device, which is suitable for probabilistic computing, and is specifically designed to address the above-mentioned key concerns.

These and other objectives are achieved by the solutions of this disclosure, which are described in the independent claims. Advantageous implementations are described in the dependent claims.

This disclosure proposes the use of 2D semiconductor layers and/or oxide semiconductor material in the FeFET device, in order to provide BEOL compatibility. Moreover, it proposes the use of ferroelectric or anti-ferroelectric layers, and optionally paraelectric layers, in a gate stack, in order to nullify the hysteresis of the FeFET. The disclosure also proposes FeFET devices in various gate configurations. Additionally, the disclosure proposes connecting in parallel multiple FeFET devices, in order to obtain efficiently tunable probabilistic samples.

A first aspect of this disclosure provides a FeFET device for probabilistic computing, the FeFET device comprising: a channel layer comprising an oxide semiconductor material and/or a 2D semiconductor material; a gate structure arranged on the channel layer, wherein the gate structure comprises a ferroelectric or anti-ferroelectric layer, and comprises a gate layer arranged on the ferroelectric or anti-ferroelectric layer; and a source contact and a drain contact arranged on the channel layer, wherein the gate structure is arranged between the source contact and the drain contact.

As mentioned, the oxide semiconductor material and/or a 2D semiconductor material provides BEOL compatibility. The ferroelectric or anti-ferroelectric layer may be used to nullify or reduce the hysteresis of the FeFET in the FeFET device.

In an implementation of the FeFET device, the gate structure further comprises a paraelectric layer, which is arranged between the channel layer and the ferroelectric or anti-ferroelectric layer of the gate structure.

The paraelectric layer in the gate stack may be used to assist in inducing and tuning the anti-ferroelectric behavior thereby reducing the ferroelectric hysteresis of the FeFET device. The paraelectric layer may comprise one or more paraelectric materials.

In an implementation of the FeFET device, a capacitor formed by a combination of the gate layer, the paraelectric layer, the ferroelectric or anti-ferroelectric layer, and a conductive channel in the channel layer has a quenched hysteresis or an anti-ferroelectric behavior.

The FeFET device having quenched (reduced or negligible) ferroelectric hysteresis offers the potential for high throughput per unit energy and area. This may enhance its suitability for probabilistic network applications.

In an implementation of the FeFET device, the source contact, the drain contact, and the gate structure are all arranged on a first surface of the channel layer.

In an implementation the FeFET device further comprises: a dielectric layer arranged on a second surface of the channel layer, which is opposite to the first surface; and a substrate layer or a wafer including front end of line, FEOL, and back end of line, BEOL, elements, arranged below the dielectric layer.

This implementation provides a top-gated (or front-gated) configuration of the FeFET device.

In an implementation of the FeFET device, one or more additional FeFET structures are arranged between the dielectric layer and the substrate layer or the wafer, each additional FeFET structure comprising a channel layer of an oxide semiconductor and/or 2D semiconductor material and a gate structure comprising a gate layer and a ferroelectric or anti-ferroelectric layer.

In an implementation, the FeFET device further comprises a second gate structure arranged on a second surface of the channel layer, which is opposite to the first surface, wherein the second gate structure comprises a second ferroelectric or anti-ferroelectric layer, and comprises a second gate layer arranged on the second ferroelectric or anti-ferroelectric layer.

This implementation provides a double-gated (front and back) configuration of the FeFET device.

In an implementation, the FeFET device further comprises two dielectric regions arranged on the second surface of the channel layer, sandwiching the second gate structure, and respectively aligned with the source contact and the drain contact on the first surface of the channel layer.

In an implementation, the FeFET device further comprises a dielectric layer arranged respectively on the gate layer and the two dielectric regions; and substrate layer arranged on the dielectric layer.

In an implementation of the FeFET device, the source contact and the drain contact are arranged on a first surface of the channel layer, and the gate structure is arranged on a second surface of the channel layer, which is opposite to the first surface.

This implementation provides a back-gated configuration of the FeFET device.

In an implementation, the FeFET device further comprises two dielectric regions arranged on the second surface of the channel layer, sandwiching the gate structure, and respectively aligned with the source contact and the drain contact on the first surface of the channel layer.

In an implementation, the FeFET device further comprises a substrate layer respectively arranged on the gate layer of the gate structure and the two dielectric regions.

In an implementation of the FeFET device, the ferroelectric or anti-ferroelectric layer comprises at least one of: doped or undoped hafnium zirconium oxide; doped hafnium oxide; doped or undoped lead zirconate titanate; doped or undoped barium titanate; doped or undoped sodium niobate; doped or undoped aluminum scandium nitride; a perovskite; a multiferroic material; a van-der-Waals layered ferroelectric material.

In an implementation of the FeFET device, the oxide semiconductor material of the channel layer comprises at least one of: indium gallium zinc oxide; indium gallium oxide; indium zinc oxide; zinc oxide; indium tin oxide; indium oxide; tungsten oxide; tungsten tin oxide; tungsten-doped indium tin oxide.

In an implementation of the FeFET device, the 2D semiconductor material of the channel layer comprises at least one of: tungsten disulfide; tungsten diselenide; tungsten ditelluride; molybdenum disulfide; molybdenum diselenide; molybdenum ditelluride.

In an implementation of the FeFET device, the paraelectric layer comprises at least one of: strontium titanate; calcium titanate; potassium tantalate; barium strontium titanate; magnesium oxide; aluminum oxide; zirconium oxide; titanium dioxide; silicon dioxide; lanthanum aluminate.

In an implementation of the FeFET device, the drain contact is connected to a supply voltage; the gate layer of the gate structure is connected to a gate voltage; and the source contact is connected to an output terminal for providing an output voltage, and is connected via at least one of an inductive load, a capacitive load, a transistor, and a resistor, to ground.

A second aspect of this disclosure provides computing device for probabilistic computing, wherein the computing device comprises a plurality of FeFET devices, each according to the first aspect or any implementation thereof, the plurality of FeFET devices being connected together in one of a neural, Ising, Bayesian, and hybrid network, via a plurality of passive or active elements.

The computing device of the second aspect enjoys the advantages of the FeFET device of the first aspect. In particular, a high throughput and efficient tunability of probabilistic samples can be achieved by using multiple of the FeFET devices. Moreover, a dense device integration at all possible network nodes can be achieved.

In this disclosure, a tunable probabilistic element (network node) with high random throughput may be implemented by the FeFET device of the first aspect. The FeFET device may thereby be a parallel connected tunable probabilistic element with one transistor (1T) and one resistor 1R (e.g., the 1T1R may be implemented by the FeFET and a reference resistor), wherein the tunable probabilistic element may have a 100 MHz to GHz sampling speed in a neural network.

In summary of the above, according to this disclosure, a top-gated, or a back-gated, or a dual-gate FeFET device can be implemented. Each may comprise a low hysteresis ferroelectric or anti-ferroelectric layer, usable to generate a random telegraphic signal. The random telegraphic signal may be generated by fluctuation of the ferroelectric layer. Such fluctuation may be controlled by varying the gate bias (voltage) applied to the gate structure of the FeFET device.

Multiple FeFET devices may be connected in parallel to increase the random telegraphic signal fluctuation speed. These FeFET devices enable 1T1R tunable probabilistic elements in a network. For example, to generate a probabilistic random number distribution with reconfigurable mean and variance, N tunable probabilistic elements can be connected, for instance, with external digital logic, or to each other with resistive banks.

### BRIEF DESCRIPTION OF THE DRAWINGS

The above described aspects and implementations are explained further in the following description of embodiments with respect to the enclosed drawings:
- FIG. 1: shows a general example of a FeFET device according to this disclosure.
- FIG. 2: shows an example of a top-gated FeFET device according to this disclosure.
- FIG. 3: shows an example of a back-gated FeFET device according to this disclosure.
- FIG. 4: shows an example of a dual-gated FeFET device according to this disclosure.
- FIG. 5: shows a top-gated or back-gated, and dual-gated, FeFET device according to this disclosure, respectively, in parallel configurations.
- FIG. 6: illustrates a 3D integration of a FeFET device according to this disclosure.
- FIG. 7: shows an example of a network of a computing device according to this disclosure.

### DETAILED DESCRIPTION OF THE DRAWINGS

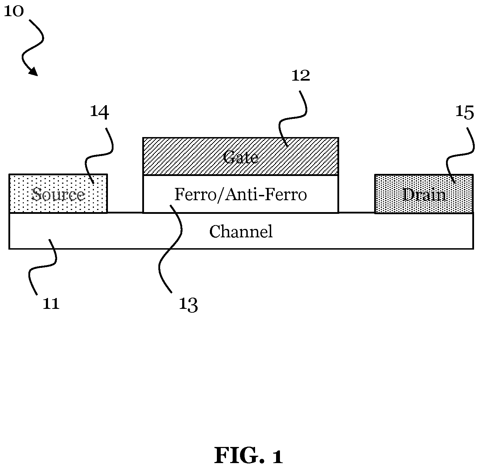

FIG. 1 shows a FeFET device 10 according to this disclosure. The FeFET device 10 is suitable for probabilistic computing. In particular, the FeFET device 10 may be used as a tunable probabilistic element in a (e.g. neural) network of a computing device for probabilistic computing.

The FeFET device 10 comprises at least a channel layer 11, a ferroelectric or anti-ferroelectric layer 13, a gate layer 12, a source contact 14, and a drain contact 15.

The channel layer 11 comprises, or is made of, an oxide semiconductor material and/or of a 2D semiconductor material. For instance, the channel layer 11 may comprise, or be made of, a 2D oxide semiconductor material, or the channel layer 11 may comprise, or be made of, an oxide semiconductor material and a 2D semiconductor material.

The ferroelectric or anti-ferroelectric layer 13 and the gate layer 12 form a gate structure. The gate structure is arranged on the channel layer 11. In particular, the ferroelectric or anti-ferroelectric layer 13 may be arranged on the channel layer 11 as shown, and the gate layer 12 is arranged on the ferroelectric or anti-ferroelectric layer 13. The ferroelectric or anti-ferroelectric layer 13 may comprise at least one of the following: doped or undoped hafnium zirconium oxide; doped hafnium oxide; doped or undoped lead zirconate titanate; doped or undoped barium titanate; doped or undoped sodium niobate; doped or undoped aluminum scandium nitride; a perovskite; a multiferroic material; a van-der-Waals layered ferroelectric material.

The source contact 14 and the drain contact 15 are both arranged on the channel layer 11, wherein the gate structure is arranged between the source contact 14 and the drain contact 15. Notably, in FIG. 1 the source/drain contacts 14, 15 and the gate structure are on the same surface of the channel layer 11, but they can also be on opposite surfaces of the channel layer 11, as described later. The gate structure is between the source/drain contacts 14, 15 regarding the horizontal axis in FIG. 1 (in-plane of the substrate and the layers). A gap may be formed between the gate structure and each of the source contact 14 and the drain contact 15. A conductive channel may form in the channel layer, and current may be sent through this channel from source to drain, or vice versa. A capacitor (also a FeFET) in the FeFET device 10, which is formed by a combination of the gate layer 12, the ferroelectric or anti-ferroelectric layer 13, and the conductive channel in the channel layer 11, may have a quenched hysteresis or an anti-ferroelectric behavior, or both.

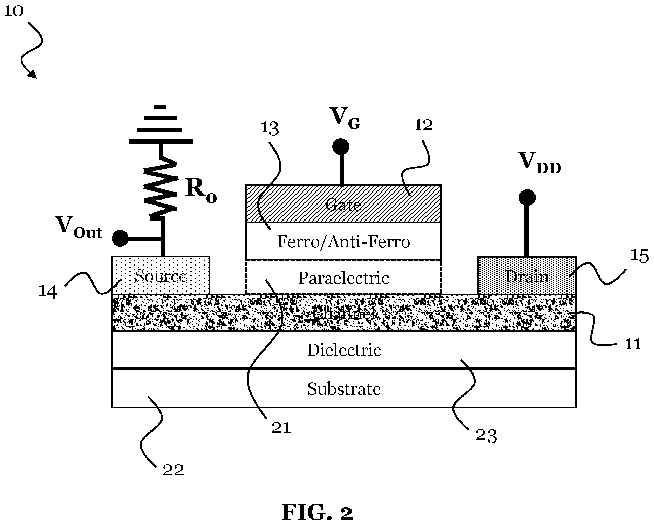

FIG. 2 shows an example of a top-gated FeFET device 10 according to this disclosure. The top-gated FeFET device 10 of FIG. 2 builds on the general implementation of FIG. 1. Same elements in FIG. 1 and FIG. 2 are labelled with the same reference signs and can be implemented likewise, wherein a redundant description is avoided.

As can be seen in FIG. 2, the source contact 14, the drain contact 15, and the gate structure are all arranged on a (same) first surface of the channel layer 11 in this configuration. The gate structure in this example further comprises a paraelectric layer 21, which is arranged between the channel layer 11 and the ferroelectric or anti-ferroelectric layer 13. Notably, this paraelectric layer 21 is an optional layer (as indicated by the dashed contours), and could be omitted such that the ferroelectric or anti-ferroelectric layer 13 would be arranged directly on the channel layer 11.

In the case where the paraelectric layer 21 is present, a capacitor formed by a combination of the gate layer 12, the paraelectric layer 21, the ferroelectric or anti-ferroelectric layer 13, and the conductive channel in the channel layer 11, may have a quenched hysteresis or an anti-ferroelectric behavior, or both.

Moreover, FIG. 2 shows that a dielectric layer 23 may be arranged on a second surface of the channel layer 11, which is opposite to the first surface. Further, a substrate layer 22 (or a wafer) may be arranged below the dielectric layer 23, i.e., on the side opposite to where the dielectric layer 23 is arranged on the channel layer 11. The layers of the FeFET device 10 may be formed or grown on or starting from the substrate layer 22. The substrate layer 22 may include front end of line (FEOL) and back end of line (BEOL) elements, which may be formed in a fabrication process of the FeFET device 10.

To enable operation of the FeFET device 10, the drain contact 15 can be connected to a supply voltage V_{DD}, the gate layer 12 of the gate structure can be connected to a gate voltage V_{G}, and the source contact 14 may be connected to an output terminal for providing an output voltage Vₒᵤₜ. Moreover, the source contact 14 may be connected via at least one of an inductive load, a capacitive load, a transistor, and a resistor, to ground. In FIG. 2, a resistor Rₒ is shown for this purpose. Rₒ is a reference resistance. As an example, a p-MOSFET can be used for implementing the reference resistance. The reference resistance can, however, be used with and without MOSFET. The source contact 14 may be connected with the reference resistance, in order to get stochastic sample at the source contact 14.

The polarization of the (reduced or zero hysteresis) ferroelectric or anti-ferroelectric layer 13 may fluctuate under thermal noise or gate bias disturb. These fluctuations may provide a random telegraphic noise, for example, in a range of a 100 MHz speed. These fluctuations can be controlled by controlling the gate voltage. That is, by changing the gate voltage to the gate layer 12 of the FeFET device 10, the switching fluctuations can be altered.

A gate area can be in the order of 30×30 nm² or less. A pitch of FeFET devices 10 may be equal to or less than 70 nm. Preferably, a domain size is equal to or larger than half a gate length of the gate structure, and a number of domains is equal to or less than, for instance, 9. A 2D channel layer mobility may be in a range of 40 cm²/Vs or more. A semiconductor oxide channel mobility may be in a range of 15 cm²/Vs or more. A transconductance of the channel formed in the channel layer 11 may be around 1×10⁻⁴ S/µm or more.

The output from the output terminal of the FeFET device 10 can be collected by using a standard inverter/amplifier. And output of the FeFET device 10, which may be used as probabilistic element, maybe sigmoid[rand(-1,1) + tanh(Vᵢ)], where Vᵢ is a gate voltage to the FeFET device 10.

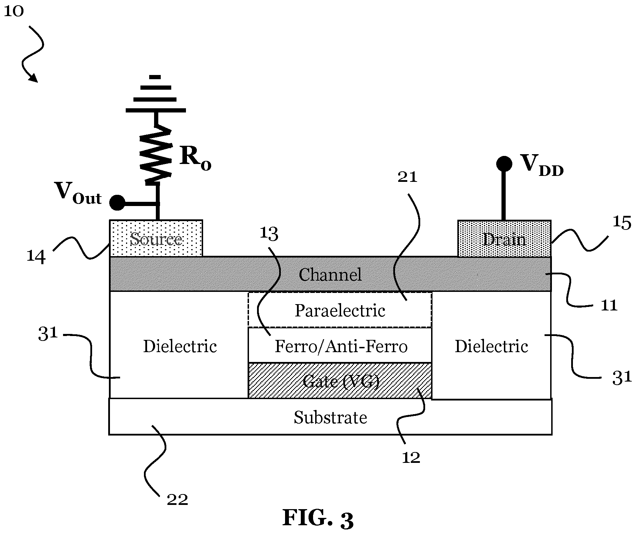

FIG. 3 shows an example of a back-gated FeFET device 10 according to this disclosure. The FeFET device 10 of FIG. 3 builds on the general implementation of FIG. 1. Same elements in FIG. 1 and FIG. 3 are labelled with the same reference signs and can be implemented likewise. A redundant description is avoided.

As can be seen in FIG. 3, the source contact 14 and the drain contact 15 are arranged on a first surface of the channel layer 11 in this example, while the gate structure is arranged on a second surface of the channel layer 11, which is opposite to the first surface. Nevertheless, horizontally the gate structure is arranged between the source contact 14 and the drain contact 15. The gate structure again comprises the paraelectric layer 21, which is in this example arranged on the second surface of the channel layer 11. The ferroelectric or anti-ferroelectric layer 13 is arranged on the paraelectric layer 21, and the gate layer 12 is arranged on the ferroelectric or anti-ferroelectric layer 13. Again, the paraelectric layer 21 is an optional layer (as indicated by its dashed contours), and could be omitted such that the ferroelectric or anti-ferroelectric layer 13 would be arranged on the second surface of the channel layer 11.

Moreover, two dielectric regions 31 are arranged on the second surface of the channel layer 11. The two dielectric regions 31 sandwich the gate structure, and are respectively aligned with the source contact 14 and the drain contact 15 that are arranged on the first surface of the channel layer 11. That is, as shown in FIG. 3, the dielectric layers 31 have respectively the same width (along the horizontal axis in FIG. 3, i.e., perpendicular to a direction of forming, e.g. growing, the layers of the FeFET device 10 above the substrate 22, which is along the vertical axis in FIG. 3) as the source contact 14 and drain contact 15, and may have the same horizontal positioning of their edges on the channel layer 11.

To enable operation of the FeFET device 10, the drain contact 15, the gate layer 12 of the gate structure, and the source contact 14 are connected as described for the FeFET device 10 of FIG. 2. The parameters of the FeFET device 10 may also be as described above with respect to FIG. 2.

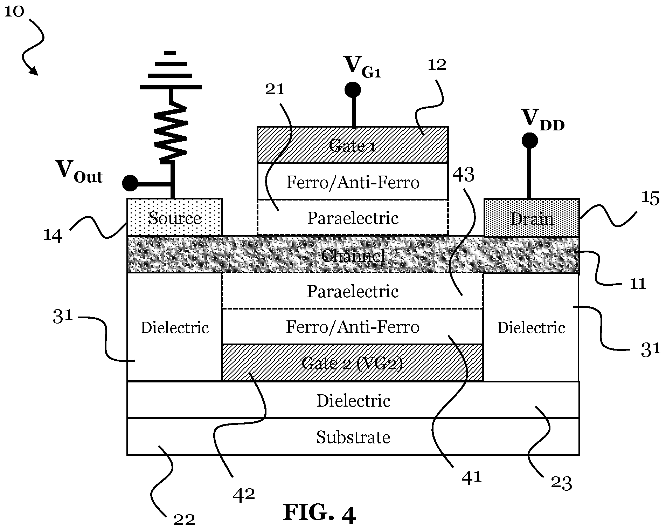

FIG. 4 shows an example of a dual-gated FeFET device according to this disclosure. The FeFET device 10 of FIG. 4 builds on the general implementation of FIG. 1. Same elements in FIG. 1 and FIG. 4 are labelled with the same reference signs and can be implemented likewise. A redundant description is avoided.

As can be seen in FIG. 4, the source contact 14, the drain contact 15 and the gate structure are arranged on a first surface of the channel layer 11. On the second surface of the channel layer 11, which is opposite to the first surface, a second gate structure is formed and arranged. The second gate structure comprises a second ferroelectric or anti-ferroelectric layer 41 and comprises a second gate layer 42. The second gate layer 42 is arranged on the second ferroelectric or anti-ferroelectric layer 41. The second ferroelectric or anti-ferroelectric layer 41 may be formed from any of the materials described above for the ferroelectric or anti-ferroelectric layer 13. Both layers 13, 41 may be the same or may be made from different materials or material combinations.

The gate structure may again comprise the paraelectric layer 21, which is arranged between the channel layer 11 and the ferroelectric or anti-ferroelectric layer 13 of the gate structure. Similarly, the second gate structure may comprise a second paraelectric layer 43, which is arranged between the channel layer 11 and the second ferroelectric or anti-ferroelectric layer 41 of the second gate structure. Both paraelectric layers 21, 43 are optional (as indicated by their dashed contours), and could be omitted such that either one or both of the ferroelectric or anti-ferroelectric layers 13, 41 would be arranged directly on the channel layer 11. The second paraelectric layer 43 may be formed from any of the materials described above for the paraelectric layer 21. Both paraelectric layers 21, 43 may be the same or may be made from different materials or material combinations.

Moreover, two dielectric regions 31 are arranged on the second surface of the channel layer 11. The two dielectric regions 31 sandwich the second gate structure, and are respectively aligned with the source contact 14 and the drain contact 15 on the first surface of the channel layer 11. This is similar and meant in the same way as described for the dielectric regions 31 with respect to FIG. 3.

To enable operation of the FeFET device 10, the drain contact 15, the gate layer 12 of the gate structure, and the source contact 14 are connected as described for the FeFET device 10 of FIG. 2. Thereby, the gate voltage V_{G1} is connected to the gate layer 12, and in addition a second gate voltage V_{G2} may be connected to the second gate layer 42. The gate layers 12 and 42 may be metal layers, for instance, typically used gate materials, for example, titanium nitride, platinum, aluminum, molybdenum, indium tin oxide (ITO), or combinations thereof.

According to the above examples and configurations, this disclosure proposes a top-gated (also referred to as front-gated), and a back-gated, and a dual-gated FeFET device 10, respectively. Each FeFET device 10 is BEOL compatible, and each FeFET device 10 may be used for implementing an efficient tunable probabilistic element of a network, being able to provide probabilistic samples in the range of 100 MHz to GHz.

The BEOL compatibility of the FeFET devices 10 can be realized by using low temperature processing compatible channel materials, that is, by using the oxide semiconductor material and/or the 2D semiconductor material. For example, BEOL compatible semiconductor oxide materials may include at least one of the following: indium gallium zinc oxide; indium gallium oxide; indium zinc oxide; zinc oxide; indium tin oxide; indium oxide; tungsten oxide; tungsten tin oxide; tungsten-doped indium tin oxide. For example, BEOL compatible 2D semiconductor materials may comprises at least one of the following: tungsten disulfide; tungsten diselenide; tungsten ditelluride; molybdenum disulfide; molybdenum diselenide; molybdenum ditelluride. Any combination of the above listed materials is possible, if both the oxide semiconductor material and the 2D semiconductor material are present. The channel in the channel layer 11 can be both 'p' and 'n' type depending on the material.

To generate a thermal excitation induced or gate bias induced random telegraphic noise in the FeFET device 10, the ferroelectric layer hysteresis may advantageously be reduced or suppressed. This can, for example, be achieved by controlling the dopant concentration ratio in the ferroelectric or anti-ferroelectric layer 13. For instance, by controlling dopants in HfxZn-xOy. The ferroelectric hysteresis can also be reduced by further using the paraelectric layer 21 between the channel layer 11 and the ferroelectric or anti-ferroelectric layer 13. The paraelectric layer 21 may tune the capacitance ratio of the ferroelectric or anti-ferroelectric layer 13 and metal oxide interfaces. The solutions of this disclosure may use either one or both approaches to reduce the hysteresis of the ferroelectric or anti-ferroelectric layer 13. Notably, the same principle applies for the second gate structure, if present in the double-gated device configuration.

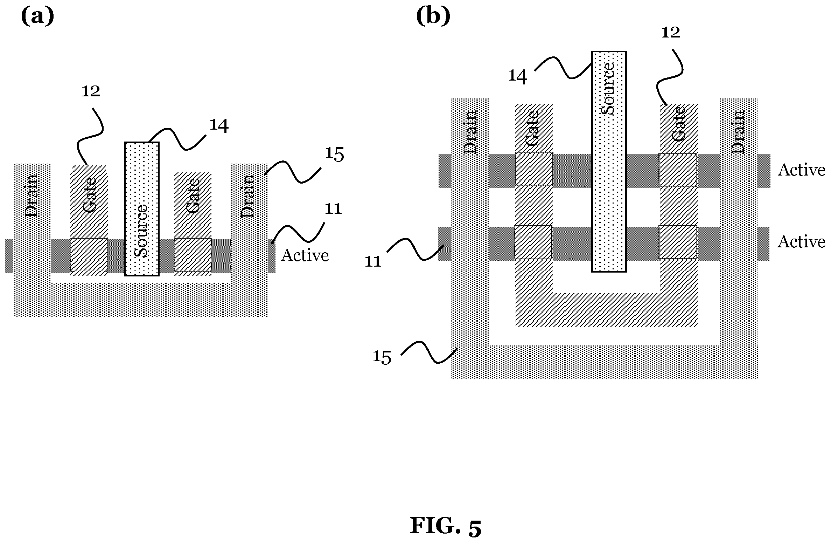

To realize an efficient tuning of the random telegraphic signal, particularly the dual-gated FeFET device 10 with both top-end and back-end configurations as shown in FIG. 5 may be used. Alternatively, top-gated and back-gated FeFET devices 10 may also be used in a parallel configuration, for instance, with dual gates as shown in FIG. 5. Dual-gated FeFET devices 10 can also be connected in parallel geometry. The parallel configuration can enhance the fluctuation speed and efficient tunability.

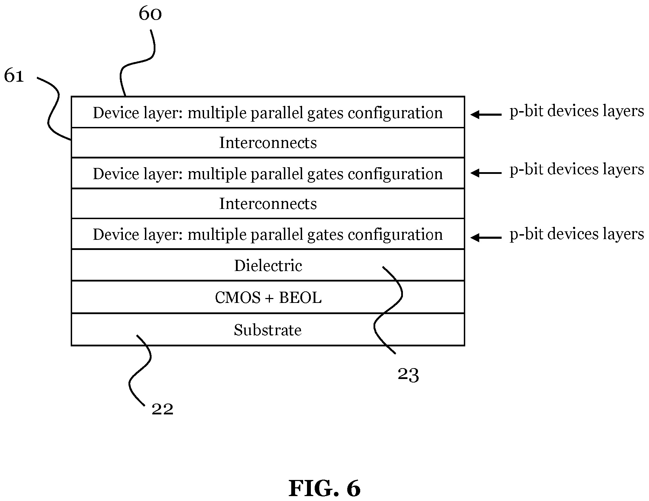

FIG. 6 shows a 3D integration of a FeFET device 10 according to this disclosure. The FeFET device 10 may comprise one or more additional FeFET structures, which can be arranged between the dielectric layer 23 and the substrate layer 22 or the wafer, for example. Each additional FeFET structure may comprise a channel layer 11 of an oxide semiconductor and/or 2D semiconductor material and a gate structure comprising a gate layer 12 and a ferroelectric or anti-ferroelectric layer 13, as described above for the single FeFET structure shown in FIG. 1-4. In FIG. 6, the device layers 60 may correspond to the FeFET structures. For instance, the device layers 60 may be p-bit device layers, which may be interconnected by interconnects 61. Each may be in parallel gate configuration. FeFET devices here may be connected with each other via interconnection both for intra- and interlayer configuration, which is subjected to the implemented network requirements.

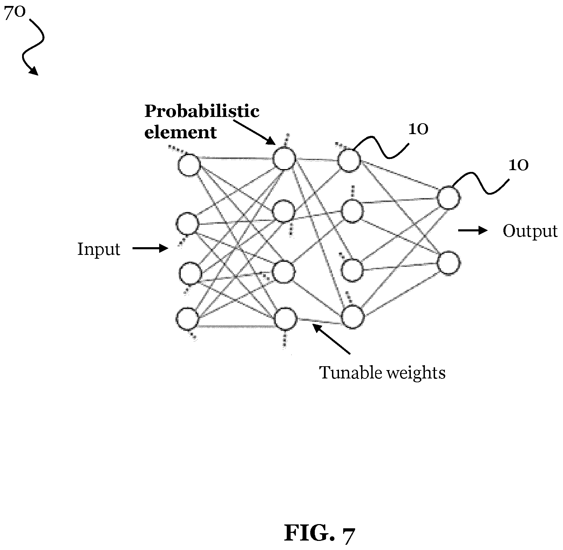

FIG. 7 shows a network 70 for a computing device according to this disclosure. The computing device of this disclosure may comprise the network 70. The network 70 may be one of a neural network (e.g., a convolutional and/or deep neural network), an Ising network, a Bayesian network, and a hybrid network. The network 70 may comprise a plurality of FeFET devices 10 as described above. A computing device of this disclosure may generally be formed with one or more FeFET devices 10 as described above.

For example, the plurality of FeFET devices 10 may be grouped into one or more blocks, for example, of N (an integer number) FeFET devices 10 each, wherein each FeFET device 10 is denoted a probabilistic element. Each block may be a probabilistic block of the network 70 comprising multiple probabilistic elements. The FeFET devices 10 may be nodes of the network, e.g. corresponding to neurons, and may be connected together via a plurality of passive or active elements, e.g. correspond to synapses.

The input at each FeFET device 10 (probabilistic element), coming from other probabilistic elements in the network, can generally be described as Iₘ = I₀ (hₘ + Σᵢ JₘᵢPᵢ), where Pᵢ is the i^{th} probabilistic element, hₘ is a bias at the i^{th} probabilistic element, and Jₘᵢ is a intercoupling between the m^{th} and the i^{th} probabilistic element. The input may specifically be the gate voltage V_{G} as described with respect to FIG. 2, and may be applied to the gate layer 12 of the respective FeFET device 10. Thus, the input may be an analog signal. The output of the FeFET device 10 may be collected at the source contact 14, as shown in FIG. 2, for example, before and after an inverter terminal.

For example, the FeFET devices 10 may be connected via tunable resistive banks or may be individually connected with digital logics to generate a reconfigurable real true random number generator (TRNG). With the FeFET devices 10 being probabilistic elements and the connecting elements being synapses, the synapses may generate a weighted sum of other probabilistic elements. A synapse can be a linear or nonlinear function, which can be implemented, for instance, by a tunable resistive bank, field effect transistors, and/or digital logic. The probabilistic elements may generate a probabilistic sample distribution, which can be manipulated by changing the applied voltage biases to the probabilistic elements and changing an inter-coupling strength generated by the synaptic weight sum. For instance, N probabilistic elements can be connected to each other via standard tunable resistive banks, field effect transistors, or digital logics to form an N-bit reconfigurable random number of a desired mean and variance. An inter-coupling strength between the probabilistic elements can be controlled by the interconnected tunable resistive elements.

The generated N bits tunable random number with reconfigurable mean and variance can be put into the Bayesian Network shown in FIG. 7. This implementation is, however, not limited to a Bayesian configuration. The N bits tunable random number can be connected to each other or can be repeated several times depending on the requirement to form a network (e.g., sparse, dense, stream, zigzag, flexible). Here, one N bits tunable random number block can connect to near neighbor blocks or far neighbor blocks depending on the network requirement. The network may connect with standard memory, RISC-V core, and input-output interface, for example, to make a complete chip.

In summary of the description above, the solutions of this disclosure offer various advantages. For instance, the FeFET device 10 may exhibit BEOL compatibility, low thermal budget, 3D integration, and may be scalable. It may be fabricated economically, e.g. with fewer processing steps compared to MRAM. The FeFET device 10 may show lower voltage operations compared to silicon channel standard FeFET devices. 100 MHz-to-GHz fluctuations are achievable.

The FeFET devices 10 may form a network of nodes, wherein the network is reconfigurable and flexible. Tunable weights and biases at the nodes may be provided. The representation of weights may be either implemented with voltage or programmable resistance. Non-linearity and feedback is possible. With the FeFET devices 10, a probabilistic neural network with a probabilistic distribution over weights may be obtained.

In the claims as well as in the description of this disclosure, the word "comprising" does not exclude other elements or steps and the indefinite article "a" or "an" does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A ferroelectric field effect transistor, FeFET, device (10) for probabilistic computing, the FeFET device (10) comprising:
a channel layer (11) comprising an oxide semiconductor material and/or a 2D semiconductor material;
a gate structure arranged on the channel layer (11), wherein the gate structure comprises a ferroelectric or anti-ferroelectric layer (13), and comprises a gate layer (12) arranged on the ferroelectric or anti-ferroelectric layer (13); and
a source contact (14) and a drain contact (15) arranged on the channel layer (11), wherein the gate structure is arranged between the source contact (14) and the drain contact (15).

2. The FeFET device (10) according to claim 1, wherein the gate structure further comprises a paraelectric layer (21), which is arranged between the channel layer (11) and the ferroelectric or anti-ferroelectric layer (13) of the gate structure.

3. The FeFET device (10) according to claim 2, wherein a capacitor formed by a combination of the gate layer (12), the paraelectric layer (21), the ferroelectric or anti-ferroelectric layer (13), and a conductive channel in the channel layer (11) has a quenched hysteresis or an anti-ferroelectric behavior.

4. The FeFET device (10) according to one of the claims 1 to 3, wherein the source contact (14), the drain contact (15), and the gate structure are all arranged on a first surface of the channel layer (11).

5. The FeFET device (10) according to claim 4, further comprising:
a dielectric layer (23) arranged on a second surface of the channel layer (11), which is opposite to the first surface; and
a substrate layer (22) or a wafer including front end of line, FEOL, and back end of line, BEOL, elements, arranged below the dielectric layer (23).

6. The FeFET device (10) according to claim 5, wherein
one or more additional FeFET structures are arranged between the dielectric layer (23) and the substrate layer (22) or the wafer, each additional FeFET structure comprising a channel layer (11) of an oxide semiconductor and/or 2D semiconductor material and a gate structure comprising a gate layer (12) and a ferroelectric or anti-ferroelectric layer (13).

7. The FeFET device (10) according to claim 4, further comprising a second gate structure arranged on a second surface of the channel layer (11), which is opposite to the first surface, wherein the second gate structure comprises a second ferroelectric or anti-ferroelectric layer (41), and comprises a second gate layer (42) arranged on the second ferroelectric or anti-ferroelectric layer (41).

8. The FeFET device (10) according to claim 7, further comprising
two dielectric regions (31) arranged on the second surface of the channel layer (11), sandwiching the second gate structure, and respectively aligned with the source contact (14) and the drain contact (15) on the first surface of the channel layer (11).

9. The FeFET device (10) according to one or the claims 1 to 3, wherein the source contact (14) and the drain contact (15) are arranged on a first surface of the channel layer (11), and the gate structure is arranged on a second surface of the channel layer (11), which is opposite to the first surface.

10. The FeFET device (10) according to claim 9, further comprising
two dielectric regions (31) arranged on the second surface of the channel layer (11), sandwiching the gate structure, and respectively aligned with the source contact (14) and the drain contact (15) on the first surface of the channel layer (11).

11. The FeFET device (10) according to one of the claims 1 to 10, wherein the ferroelectric or anti-ferroelectric layer (13) comprises at least one of:
doped or undoped hafnium zirconium oxide;
doped hafnium oxide;
doped or undoped lead zirconate titanate;
doped or undoped barium titanate;
doped or undoped sodium niobate;
doped or undoped aluminum scandium nitride;
a perovskite;
a multiferroic material;
a van-der-Waals layered ferroelectric material.

12. The FeFET device (10) according to one of the claims 1 to 11, wherein the oxide semiconductor material of the channel layer (11) comprises at least one of:
indium gallium zinc oxide;
indium gallium oxide;
indium zinc oxide;
zinc oxide;
indium tin oxide;
indium oxide;
tungsten oxide;
tungsten tin oxide;
tungsten-doped indium tin oxide.

13. The FeFET device (10) according to one of the claims 1 to 12, wherein the 2D semiconductor material of the channel layer (11) comprises at least one of:
tungsten disulfide;
tungsten diselenide;
tungsten ditelluride;
molybdenum disulfide;
molybdenum diselenide;
molybdenum ditelluride.

14. The FeFET device (10) according to one of the claims 1 to 13, wherein
the drain contact (15) is connected to a supply voltage;
the gate layer (12) of the gate structure is connected to a gate voltage; and
the source contact (14) is connected to an output terminal for providing an output voltage, and is connected via at least one of an inductive load, a capacitive load, a transistor, and a resistor, to ground.

15. A computing device for probabilistic computing, wherein the computing device comprises a plurality of FeFET devices (10), each according to one of the claims 1 to 14, the plurality of FeFET devices (10) being connected together in one of a neural, Ising, Bayesian, and hybrid network (70), via a plurality of passive or active elements.
